# EUROPÄISCHE PATENTSCHRIFT

(11) **EP 4 186 651 B1**
(45) Veröffentlichungstag und Bekanntmachung des Hinweises auf die Patenterteilung: **03.01.2024**
(21) Anmeldenummer: 22184247.9
(22) Anmeldetag: 12.07.2022
(51) Int. Cl.: B25J 9/16, G05B 17/02, G06F 3/01, G06F 30/12, G06F 30/18, G06K 7/10, G06K 7/14

(54) **SYSTEM UND VERFAHREN MIT EINEM SYSTEM**
SYSTEM AND METHOD WITH A SYSTEM
SYSTÈME ET PROCÉDÉ DOTÉ D'UN SYSTÈME

(30) Priorität: 26.11.2021 DE 102021131060
(43) Veröffentlichungstag der Anmeldung: 31.05.2023
(73) Patentinhaber: SICK AG, 79183 Waldkirch (DE)
(72) Erfinder: STEINKEMPER, Heiko, 79100 Freiburg (DE); HOFMANN, Christoph, 79108 Freiburg (DE); BIRKENMAIER, Dominik, 79112 Freiburg (DE); GEBAUER, Jens, 79183 Waldkirch (DE)

(56) Entgegenhaltungen:
- EP-A1- 3 578 321
- EP-A1- 3 705 239
- DE-A1-102005 025 470
- US-A1- 2021 154 844

## Beschreibung

Die vorliegende Erfindung betrifft ein System gemäß dem Oberbegriff von Anspruch 1 und ein Verfahren mit einem System gemäß dem Oberbegriff von Anspruch 15.

Anwendungen bzw. Applikationen, beispielsweise in der Mensch-Roboter-Kollaboration (MRK) sind oft schwer zu planen. Dies betrifft beispielsweise nicht nur die Roboterbahn an sich, sondern insbesondere die Einbindung von Sensoren. Diese Sensoren können sowohl Automatisierungs- als auch Sicherheitssensoren sein. Diese zeichnen sich immer durch ihren Wirkbereich, beispielsweise das FOV einer Kamera oder die Reichweite eines Scanners und durch ihre Funktion, beispielsweise ein gebildetes Schutzfeld aus. Oft ist es in einer MRK Applikation entscheidend, wo ein Sensor angebracht ist und wie er in den Applikationskontext eingebettet ist. Oft ist letzteres ein Trial-and-Error-Vorgehen, was zeit- und damit kostenintensiv ist. Dieser Schritt ist oft nur mit den echten Sensoren also während der Integration der Applikation machbar.

Die EP3578321A1 offenbart ein Verfahren zum Verwenden mit einer Maschine, insbesondere eines mobilen oder stationären Roboters, insbesondere eines Knickarmroboters. Das Verfahren weist eine Kalibrierung einer Erweiterte-Realität-Anzeigeumgebung auf, nämlich durch Bestimmen einer relativen Pose zwischen der Maschine und einer Bildaufnahmeeinrichtung durch Erkennen der Maschine und/oder eines oder mehrerer Teile der Maschine in einem aufgenommenen Bild basierend auf einem dreidimensionalen Maschinenmodell. Ferner wird ein Koordinatenabgleich zwischen einem Maschinenkoordinatensystem der Maschine und einem Koordinatensystem der Bildaufnahmeeinrichtung basierend auf der bestimmten relativen Pose durchgeführt.

Die US2021154844A1 offenbart ein Simulationsgerät. Das Simulationsgerät umfasst einen Bildsensor, der ein Bild eines realen Raums einschließlich eines tatsächlichen Roboters und eines an der Peripherie des tatsächlichen Roboters angeordneten Peripheriegeräts erfasst, einen Augmented-Reality-Anzeigeabschnitt, der einen virtuellen Roboter anzeigt, der über dem dargestellten tatsächlichen Roboter liegt erfasstes Bild, einen Werkstückverwaltungsabschnitt, der die Position eines sich bewegenden Werkstücks verwaltet, und einen Bewegungssteuerungsabschnitt, der eine Bewegung des virtuellen Roboters auf der Grundlage der Position des Werkstücks steuert.

Die DE102005025470A1 offenbart ein Verfahren zur Ermittlung der Position und Orientierung einer Kamera relativ zu einem realen Objekt, bei dem mit einer Kamera ein zweidimensionales Bild aufgenommen wird, welches wenigstens ein Objekt beinhaltet, das sich in einer realen Umgebung befindet, bei dem im Zuge der Aufnahme des zweidimensionalen Bildes ein aktueller Bilddatensatz erzeugt wird, bei dem bei Bedarf Bildmerkmale im zweidimensionalen Bild bestimmt werden, bei dem ein Verfahren zur Verfolgung von Bildmerkmalen zwischen einem vorliegenden Bilddatensatz und dem aktuellen Bilddatensatz durchgeführt wird, bei dem ein Optimierungsverfahren durchgeführt wird, welches ein Datenmodell einer virtuellen Information mit zu bestimmenden Kameraparametern auf die Bildebene projiziert, um eine Projektion des Datenmodells mit dem Abbild des realen Objekts auf der Bildebene zu überlagern, und welches aktuelle Kameraparameter durch Bestimmung von Extremwerten einer Kostenfunktion bestimmt, die als Parameter Bilddaten aus dem aktuellen Bilddatensatz und Daten des projizierten Datenmodells beinhaltet.

Die EP3705239A1 offenbart ein Kalibriersystem und eine Methode für Roboterzellen, einschließlich Kameras, Roboter, Objekte, Objektbewegungsmechanismen und Robotersteuerungen. Die Robotersteuerung umfasst Software, die eine virtuelle Roboterzelle generiert, die einen virtuellen dreidimensionalen Raum definiert, in dem virtuelle Kameras, virtuelle Roboter und virtuelle Objekte positioniert und manipuliert werden. Die Robotersteuerung erstellt eine Vielzahl virtueller Schnappschüsse der virtuellen Roboter in verschiedenen Posen und virtueller Objekte aus verschiedenen virtuellen Kamerawinkeln und -positionen. Die Robotersteuerung steuert auch die realen Kameras, um mehrere reale Schnappschüsse der Roboter und Objekte in denselben Roboterposen und Kamerapositionen wie die virtuellen Schnappschüsse zu machen. Die Robotersteuerung vergleicht virtuelle Schnappschüsse mit passenden realen Schnappschüssen und ermittelt die am besten passenden virtuellen und realen Schnappschüsse. Die erkannten Unterschiede werden zur Anpassung der Kalibrierung verwendet, wodurch die Roboterfehlerrate basierend auf Positions- und Ausrichtungsfehlern reduziert wird.

Eine Aufgabe der Erfindung besteht darin, ein verbessertes System und ein Verfahren mit einem System zur Planung einer Anwendung bereitzustellen.

Die Aufgabe wird gemäß Anspruch 1 gelöst durch ein System zur Planung einer Anwendung mit mindestens einer Markierung mit einer Steuer- und Auswerteeinheit, mit einer Datenbank, mit einer Anzeigeeinheit, und mit mindestens einem räumlichen Modell einer realen Umgebung, und mindestens einer Kamera zur Abbildung der realen Umgebung, wobei die reale Umgebung in dem räumlichen Modell als virtuelle Umgebung auf der Anzeigeeinheit anzeigbar ist, wobei die Markierung in der realen Umgebung an einer Position und mit einer Orientierung angeordnet ist, wobei die Position und die Orientierung der Markierung mindestens von der Kamera erfassbar sind, wobei die Position und Orientierung der Markierung mit einem virtuellen Sensormodell ver knüpft sind, wobei das virtuelle Sensormodell in dem räumlichen Modell der virtuellen Umgebung auf der Anzeigeeinheit an der Position und mit der Orientierung der Markierung anzeigbar ist, wobei das virtuelle Sensormodell mindestens einen virtuellen Erfassungsbereich aufweist, wobei der virtuelle Erfassungsbereich in dem räumlichen Modell der virtuellen Umgebung auf der Anzeigeeinheit anzeigbar ist.

Die Aufgabe wird weiter gemäß Anspruch 15 gelöst mit einem Verfahren mit einem System zur Planung einer Anwendung mit mindestens einer Markierung, mit einer Steuer- und Auswerteeinheit, mit einer Datenbank, mit einer Anzeigeeinheit, und mit mindestens einem räumlichen Modell einer realen Umgebung, und mindestens einer Kamera zur Abbildung der realen Umgebung, wobei die reale Umgebung in dem räumlichen Modell als virtuelle Umgebung auf der Anzeigeeinheit angezeigt wird, wobei die Markierung in der realen Umgebung an einer Position und mit einer Orientierung angeordnet wird, wobei die Position und die Orientierung der Markierung mindestens von der Kamera erfasst wird, wobei die Position und Orientierung der Markierung mit einem virtuellen Sensormodell verknüpft wird, wobei das virtuelle Sensormodell in dem räumlichen Modell der virtuellen Umgebung auf der Anzeigeeinheit an der Position und mit der Orientierung der Markierung angezeigt wird, wobei das virtuelle Sensormodell mindestens einen virtuellen Erfassungsbereich aufweist, wobei der virtuelle Erfassungsbereich in dem räumlichen Modell der virtuellen Umgebung auf der Anzeigeeinheit angezeigt wird.

Es wird beispielsweise ein Set von N Markierungen bzw. Markern bzw. sog. visuellen Tags vorgesehen. Die Markierung bzw. die Markierungen werden in einer Umgebung einer geplanten Anwendung bzw. Applikation platziert oder angeordnet. Beispielsweise fest an einer Infrastruktur z.B. an einer Wand oder an einem Arbeitsplatz. Beispielsweise ist die Position eine ortsfeste Position und die Orientierung eine ortsfeste Orientierung.

Beispielsweise sind die Markierungen an Manipulatoren z.B. an einem Roboter oder an mobilen Plattformen angeordnet. Beispielsweise ist die Position dann eine bewegliche veränderliche Position und die Orientierung ist eine bewegliche veränderliche Orientierung.

Jeder Markierung kann nun per Software-Anwendung oder APP-Anwendung, also mittels einer graphischen Bediensoftware mittels der Steuer- und Auswerteeinheit ein virtuelles Sensormodell zugeordnet werden, welches in Augmented Reality also einer erweiterten Realität orientierungsgetreu mit Hilfe der Anzeigeeinheit bzw. eines mobilen Endgeräts dargestellt wird. Insbesondere wird dabei auch der Erfassungsbereich bzw. Wirkbereich des virtuellen Sensors und die Sensorfunktion des virtuellen Sensors in der erweiterten Realität dargestellt. Beispielsweise können die Markierung oder die Markierungen fortlaufend nachverfolgt (tracking) werden so dass das mobile Endgerät und die Markierung bzw. Markierungen beweglich sein können. Bei dem Erfassungsbereich kann es sich beispielsweise um ein Erfassungsfeld, einen Schutzbereich, ein Schutzfeld, ein Warnbereich, ein Warnfeld oder ähnliches handeln.

Die Umgebung bzw. ein Umweltmodell umfasst hier auch beispielsweise Menschen, die sich in der realen Umgebung, beispielsweise einer Industrieszene befinden. Die Markierungen werden nun dazu verwendet einer georteten Markierung die entsprechende Sensorfunktion an Ort und Stelle bzw. der Position in korrekter Orientierung zuzuordnen und zu visualisieren.

Dabei penetrieren die Wirkbereiche der virtuellen Sensoren keine virtuelle Infrastruktur, d.h. z.B. Wände, Fußböden oder Personen werden in der Augmented Reality Visualisierung nicht durchstrahlt, sondern beispielsweise fotorealistisch getroffen. Ähnlich wie mit "Post-it-Notizen" kann so eine Applikation interaktiv und/oder immersiv sehr effizient und nachvollziehbar geplant werden.

Die erfindungsgemäße Lösung verbessert eine Planungsphase einer Anwendung, in der in der Regel kein realer Sensor verfügbar ist oder noch kein realer Sensor eingesetzt werden soll, um Kosten zu sparen.

Sensoren werden nur durch die Markierung repräsentiert, der bestimmte Sensoreigenschaften zugewiesen werden können. Die einer Markierung zugewiesenen Sensoreigenschaften werden augmentiert visualisiert und unterstützen die Planung der Applikation, d.h. eine optimale Wahl der Art der Sensoren, einer Anzahl von Sensoren, einer Anordnung der Sensoren und/oder eine Konfiguration bzw. Einstellungen der Sensoren. Beispielsweise ist eine Visualisierung einer Synchronisation oder gegenseitige Störung von Sensoren vorgesehen. So kann beispielsweise ein abwechselndes Pulsen von Sensoren gezeigt werden.

Diese augmentierte bzw. virtuelle Planung geht weit über die Möglichkeiten einer rein digitalen Planung am PC hinaus. Insbesondere eröffnet sie gerade für das Thema Sicherheit im Sinne von funktionaler Sicherheit bzw. Maschinensicherheit in komplexen Applikationen z.B. in den Mensch-Roboter-Applikationen neue Möglichkeiten sich in die Applikation hineinzuversetzen und so potenziell gefährliche Situationen zu identifizieren und bereits in der Planung zu eliminieren.

Sicherheits-Experten können damit gemeinsam mit Werkern, noch vor Kauf, Installation, Inbetriebnahme und/oder reale Arbeitssituationen durchspielen und sichere und produktive Arbeitsabläufe planen. Hierdurch können beispielsweise Sicherheitslücken bzw. Lücken im kombinierten Schutzfeld aller geplanten Sensoren und damit der gesamten Sicherheitslösung identifiziert werden. Um dies zu visualisieren erfolgt die Ausmessung und die Identifizierung wie die Markierungen bzw. Marker relativ zueinander liegen.

Bei einer Veränderung einer Markierungsposition oder dem Hinzufügen einer weiteren Markierung braucht nur der Bereich um die neue Position aufgenommen werden, bis der Algorithmus genügend Referenzen hat, um die Markierung korrekt neu zu platzieren in der virtuellen Umgebung. Dies könnte auch in Echtzeit erfolgen, sofern das zur Visualisierung verwendete Endgerät über die entsprechende Sensorik verfügt.

Hierdurch könnten versehentliche und absichtliche Positionsänderungen von Markierungen automatisch erkannt, angezeigt und sofern gewünscht im Umgebungsmodell korrigiert werden. Erfolgt die Umgebungserfassung in Echtzeit z.B. über das zur Visualisierung genutzte Endgerät können auch bewegliche Objekte berücksichtigt werden.

Nach erfolgreicher Planung können die Ergebnisse mittels Screenshots oder Videos dokumentiert werden und in die Applikationsdokumentation überführt werden, z.B. im Rahmen eines Risiko Assessment.

Die in der Simulation verwendeten virtuellen Sensoren können beispielsweise in einem Werkzeug der Steuer- und Auswerteeinheit in einen Einkaufskorb platziert werden und vom Kunden als reale Sensoren bezogen werden.

Aus der Simulation gebildete Sensor-Konfigurationen können beispielsweise als Parameterdatei ebenfalls an Kunden geliefert werden. Dadurch wird neben der einfachen und schnellen Planung von Applikationen auch die einfache und schnelle Einrichtung der realen Applikation ermöglicht und gefördert.

Die in der realen Umgebung angebrachten Markierungen können einem Integratoren-Team auch als Montagehinweis dienen. Beispielsweise können in der virtuellen Umgebung Montagehinweise, insbesondere Textnachrichten eingeblendet werden, beispielsweise mit dem Wortlaut: "Hier bitte einen Sensor X in dieser dargestellten Orientierung Y mit einem Parameterset Z anbringen".

Planerische Risiken werden in der künstlichen bzw. erweiterten Realität gelöst. Die eigentliche Integration erfordert in dieser Vorgehensweise einen minimalen Zeitaufwand. Eine Stillstandzeit einer beispielsweise bestehenden Anwendung für einen Umbau ist damit minimiert. Abweichungen zwischen Planungsstand (z.B. Umgebungsmodell aus CAD-Daten) und realer Applikation werden durch das virtuelle Sensorverhalten sichtbar gemacht. Mit dieser Vorgehensweise lassen sich Applikationen sehr einfach und intuitiv umplanen und die beste gefundene Lösung wird anschließend in der Realität mit realen Sensoren umgesetzt.

Die erfindungsgemäße Lösung erlaubt eine Unterstützung neuer digitaler Konfigurations- und Bestellprozesse. Ein Kunde kann über beispielsweise eine Hersteller-APP inkl. einer Sensorbibliothek die Applikation virtuell planen, Sensor-Konfiguration speichern und direkt aus der App eine Bestellung inkl. Parameter-Dateien in Auftrag geben. Alternativ kann die Konfiguration bereits über den Bestellprozess auf dem gewünschten realen Sensor aufgespielt werden. Es kann ein Angebot von weiteren Services, wie Risiko Assessment basierend auf dem vom Kunden zur Verfügung gestellten Umweltmodell inkl. Sensoranordnung, erfolgen.

Die Kosten der Lösung sind anhand der verwendeten Komponenten ebenfalls vor einer konkreten Realisierung genau bekannt, so dass eine sehr fundierte Kosten-Nutzen-Analyse für die Applikation möglich ist, ohne dass eine einzige Komponente bzw. ein Sensor real beschafft und angebracht wurde und darüber hinaus auch nicht in jeder Planung erneut eine spezifische Simulation programmiert werden müsste, da diese aus der augmentierten Lösung erzeugt wird.

In Weiterbildung der Erfindung ist das räumliche Modell auf Basis einer realen Umgebung als 3D-CAD-Modell vorhanden. Das räumliche Modell kann aus einem 3D-CAD-Modell abgeleitet werden und z.B. als vernetzte Oberfläche verwendet werden.

Beispielsweise ist ein globaler oder übergeordneter Marker bzw. Markierung vorgesehen, dessen Pose relativ zum 3D-CAD-Modell bekannt ist. Von diesem ausgehend können die Markierungen der virtuellen Sensoren eingemessen werden. Intern wird dabei beispielsweise ein Graph aufgebaut, wobei die Marker die Knoten sind und die Kanten die Transformationen zwischen den Markern repräsentieren. Das ist beispielsweise auch wichtig um die Wirkbereiche mehrerer Sensoren an ihren Schnittstellen zu inspizieren.

Gemäß der Weiterbildung ist eine Applikationsplanung durch den Anwender in der künftigen Produktionsumgebung möglich, beispielsweise eine Mensch-Roboter-Kollaboration (MRK). Ein Anwender erstellt ein 3D-CAD-Modell bzw. ein 3D Umweltmodell in der virtuellen Umgebung. Es erfolgt eine Simulation und Visualisierung der Absicherung der Gefahrenstellen durch Platzieren von Tags in der Umgebung die flexibel über eine SICK Bibliothek mit verschiedenen virtuellen Sensoren und deren Eigenschaften verknüpft werden können. Der Anwender kann so seine Applikation virtuell planen und simulieren, Sensor-Konfigurationen speichern und über die APP eine individualisierte Bestellung aufgeben. Der Kunde erhält, auf Basis seines Umweltmodels, vorkonfigurierte Sensoren inkl. Montagehinweis. Nach Installation der realen Applikation kann eine Validierung vorgenommen werden, wobei die Simulation in der virtuellen Umgebung mit der realen Anwendung verglichen wird. Abweichungen werden erkannt und können nachjustiert werden.

Wie bei der beschriebenen Mensch-Roboter-Kollaboration (MRK) Anwendung kann beispielsweise bei einer autonomen mobilen Roboteranwendung (AMR) ebenfalls die Applikationsplanung von Workstations durchgeführt werden. Dazu erstellt der Anwender ein 3D-CAD-Modell bzw. ein 3D Umweltmodell in der virtuellen Umgebung. Durch Platzieren von Markierungen oder Markern, die mit virtuellen Sensoren und deren Eigenschaften verknüpft sind, lässt sich die Absicherung der Gefahrenstelle simulieren und visualisieren. Ebenfalls kann der Anwender so seine Applikation in Augmented Reality planen und simulieren, Sensor-Konfigurationen speichern und über die App eine individualisierte Bestellung aufgeben. Darüber hinaus können bei einer autonomen mobilen Roboteranwendung (AMR) nicht nur Workstations simuliert und visualisiert werden, sondern auch Wegabschnitte. Dazu kann ein live 3D Umweltmodell erstellt werden und potenzielle Gefahrenstellen in der Wegplanung simuliert werden.

In Weiterbildung wird oder wurde das räumliche Modell mittels einem 3D-Sensor gebildet. Beispielsweise kann das räumliche Modell vorab mittels einem 3D-Sensor gebildet werden. Dazu wird beispielsweise eine reale Umgebung räumlich gescannt und das räumliche Modell vorab gebildet. Alternativ kann das räumliche Modell in Echtzeit aktuell mittels dem 3D-Sensor gebildet werden.

Ein Umgebungsmodell kann somit vorab zur Verfügung gestellt werden. Es kann mit 3D-Sensoren aufgezeichnet werden mit anschließender 3D-Kartengenerierung. Es kann mit Laserscannern aufgenommen werden mit anschließender Map-Generierung.

In Weiterbildung der Erfindung ist die Position und die Orientierung der Markierung von dem 3D-Sensor und der Kamera (7) erfassbar.

Beispielsweise ortet ein digitales Endgerät, hierfür mit dem 3D-Sensor optisch die Position und Orientierung der Markierungen in der Umgebung der Anwendung mit dem 3D-Sensor und der Kamera. Hierbei werden beispielsweise drei unterschiedliche Raumrichtungen und drei unterschiedliche Orientierungen, also sechs Freiheitsgrade der Markierung ermittelt. Der 3D-Sensor erzeugt dabei das dazugehörige virtuelle Umweltmodell bzw. ein situatives Umweltmodell.

Dabei kann eine Kenntnis über die relative Lage der Markierung auch bei einer Ortsveränderung bzw. einer Orientierungsänderung der Markierung aktualisiert werden. Auch hierzu können die bereits mehrfach erwähnten Endgeräte verwendet werden, die mit der Kamera, dem 3D-Sensor und der Anzeigeeinheit ausgestattet sind.

Aus der Kombination von Bilddaten der Kamera und von erzeugten Tiefenkarten des 3D-Sensors bei der Aufnahme der Umgebung und Erzeugung des Umgebungsmodells, können so die bereits platzierten Markierungen in der Applikation erkannt und auch einem Ort bzw. Koordinaten in der Umgebung zugeordnet werden.

In Weiterbildung der Erfindung ist der 3D-Sensor eine Stereokamera oder ein Lichtlaufzeitsensor.

Beispielsweise ortet ein digitales Endgerät, beispielsweise ein iPhone 12 Pro oder ein iPad Pro hierfür mit dem Lichtlaufzeitsensor optisch die Position und Orientierung der Markierungen in der Umgebung der Anwendung mit dem Lichtlaufzeitsensor und der Kamera. Hierbei werden beispielsweise drei unterschiedliche Raumrichtungen und drei unterschiedliche Orientierungen, also sechs Freiheitsgrade der Markierung ermittelt. Der Lichtlaufzeitsensor, beispielsweise ein LIDAR Scanner erzeugt dabei das dazugehörige virtuelle Umweltmodell bzw. ein situatives Umweltmodell.

Beispielsweise ortet ein digitales Endgerät, beispielsweise ein Smartphone oder ein Tabletrechner hierfür mit einer integrierten Stereokamera optisch die Position und Orientierung der Markierungen in der Umgebung der Anwendung mit der Stereokamera und der Kamera. Hierbei werden beispielsweise drei unterschiedliche Raumrichtungen und drei unterschiedliche Orientierungen, also sechs Freiheitsgrade der Markierung ermittelt. Die Stereokamera erzeugt dabei das dazugehörige virtuelle Umweltmodell bzw. ein situatives Umweltmodell.

In Weiterbildung der Erfindung ist der Lichtlaufzeitsensor ein Laserscanner oder eine 3D-Lichtlaufzeitkamera.

Die Umgebung kann beispielsweise als Echtzeitumgebungsmodell mit dem Lichtlaufzeitsensor, beispielsweise einer 3D-Lichtlaufzeitkamera bzw. einer Lidar Kamera oder einem Laserscanner aufgenommen werden. Erfindungsgemäß kann das Echtzeitumgebungsmodell mit 2D-Bilddaten aus der Kamera, beispielsweise dem mobilen Endgerät kombiniert werden, so dass basierend auf den Tiefendaten eine Echtzeitsegmentierung vorgenommen wird. Auf diese Weise kann beispielsweise ein Fußboden, eine Wand, ein Arbeitsplatz und/oder eine Person identifiziert werden.

Übertragen auf einen industriellen Sicherheitskontext sowie eine Augmented Reality basierte MRK Applikationsplanung könnte dies in einem Beispiel mit drei Markierungen, die jeweils einen virtuellen Laserscanner repräsentieren, folgendermaßen aussehen.

Zwei Markierungen sind beispielsweise an einem Roboter ortsfest angeordnet und sollen einen bestimmten Bereich um den Roboter erfassen und absichern. Es ist vorgesehen, dass man diesen Bereich ebenfalls per mobilem Endgerät in der Applikation eingibt bzw. einzeichnet und somit Bereiche identifiziert, die nicht von den Sicherheitssensoren in ihrer aktuellen Anbringung und Konfiguration erfasst werden. Solche Bereiche entstehen z.B. hinter statischen Objekten, an denen die Schutzfelder aufgrund der eingelernten Umgebungsdaten abgeschnitten werden.

Auch an bewegten Hindernissen, wie z.B. dem Werker oder dem AGC können die Schutzfelder unterbrochen bzw. abgeschnitten werden sofern z.B. ein Augmented Reality Gerät mit 3D-Sensorik oder ein weiteres 3D-Daten lieferndes Gerät verwendet wird. Zur Trennung von eingelernten Umgebungsdaten und dynamischem Objekt wäre beispielsweise eine Segmentierung z.B. der Person im Farbbild und anschließendes Mapping auf 3D Daten vorgesehen. Prinzipiell sind auch Markierungen an beweglichen Maschinenteilen oder Fahrzeugen vorgesehen.

Eine Korrespondenz zwischen den Markierungen und den virtuellen Sensoren kann beispielsweise wie folgt aussehen:
Die Datenmodelle von virtuellen Sensoren sind beispielsweise in einer Bibliothek der Datenbank abgelegt. Diese Bibliothek umfasst beispielsweise für jeden Sensor das 3D-CAD-Modell, einen Wirkbereich und ein Set an Funktionen. Zusätzlich werden beispielsweise für jeden Sensor Metadaten abgelegt, diese können beispielsweise einen Sensortyp (z. B. Laserscanner, 3D-Lichtlaufzeitkamera, etc), physikalische Anschlüsse (z. B. Ethernet, IO-Link, etc) oder einen Performance Level umfassen. Die Bibliothek bzw. Sensorbibliothek kann mit Suchfiltern ausgestattet sein, so dass der Anwender entscheiden kann, welche virtuellen Sensoren er für die Zuordnung verwenden möchte (z.B. eine 3D-Lichtlaufzeitkamera mit 940 nm Wellenlänge, 3 m Reichweite, 70° Sichtbereich und Ethernet Anschluss). Einem morphologischen Kasten ähnelnd können den Markierungen unterschiedliche Sensoren zugeordnet werden, die dann zur Planung der Applikation verwendet werden.

Ein Umgebungsmodell kann auch vorab zur Verfügung gestellt werden. Es kann mit 3D-Sensoren aufgezeichnet werden mit anschließender 3D-Kartengenerierung. Es kann mit Laserscannern aufgenommen werden mit anschließender Map-Generierung. Es kann aus einem 3D-CAD-Modell abgeleitet werden und z.B. als vernetzte Oberfläche verwendet werden.

In Weiterbildung der Erfindung sind die Markierungen mindestens zweidimensionale Matrixkodierungen. Dabei ist aus der zweidimensionalen Matrixkodierung die eindeutige Richtung und die eindeutige Orientierung der Markierung erkennbar und ermittelbar. Die Matrixkodierung kann optional die Art des Sensors, sowie weitere Eigenschaften des Sensors, wie beispielsweise eine Schutzfeldgröße, eine Schutzfeldrichtung und eine Schutzfeldorientierung aufweisen. Beispielsweise weist die Markierung eine zweidimensionale Kodierung auf und zusätzlich noch Farbinformationen.

Die visuellen Markierungen können beispielsweise AprilTags bzw. AprilMarker sein. Diese haben gegenüber einem QR-Code weniger Informationen und sind dennoch orientierungssensitiv. AprilTags Markierungen weisen beispielsweise eine weiße Umrandung auf und beinhalten darin eine beispielsweise 8x8 Matrix von schwarzen und weißen Feldern als Matrix Code.

Es kommen auch sog. ArUco Tags in Frage. Ein ArUcoTag bzw. ArUco-Marker ist ein synthetischer, quadratischer Marker, der aus einem breiten schwarzen Rand und einer inneren binären Matrix besteht, die seinen Identifikator (id) bestimmt. Der schwarze Rand erleichtert seine schnelle Erkennung im Bild und die binäre Kodierung ermöglicht seine Identifizierung und die Anwendung von Fehlererkennungs- und Korrekturtechniken. Die Größe der Markierung bestimmt die Größe der internen Matrix. Eine Markergröße von 4x4 besteht zum Beispiel aus 16 Bits.

Es können auch Vuforia-Marker "Vu-Mark" eingesetzt werden. Vuforia-Marker weisen eine Kontur, einen Grenzbereich, einen freien Abstandsbereich, Kode-Elemente und einen Hintergrundsbereich auf. Es ist möglich und vorgesehen, dass auf dem Tag noch weitere Informationen gespeichert werden. Z.B: Datenblätter, Zertifikate, User Manuals, usw.

In Weiterbildung der Erfindung sind die Markierungen mindestens reale 3D-Modelle. Dabei kann es sich beispielsweise um kleine räumliche Sensormodelle aus Schaumstoff oder anderen Materialien handeln. Die Markierung wird dabei über die 3D-Kontur des Sensormodells gebildet.

In Weiterbildung der Erfindung ist die Markierung mittels einer Haltevorrichtung in der realen Umgebung angeordnet.

Beispielsweise sind universell passende Aufhängungen vorgesehen, um die Markierungen zur Planung möglichst frei in der Applikation platzieren zu können. Beispielsweise ist ein modulares Anbringungskonzept bestehend aus Grundplatte mit der Markierung in Kombination mit wahlweise einer magnetischen Vorrichtung, einer Klebevorrichtung, einer Klemmvorrichtung und/oder einer Schraubvorrichtung vorgesehen.

In Weiterbildung der Erfindung ist die Position und Orientierung einer zweiten Markierung mit einem virtuellen Objekt verknüpft, wobei das virtuelle Objekt in dem räumlichen Modell der Umgebung auf der Anzeigeeinheit an der Position und mit der Orientierung der zweiten Markierung angezeigt wird.

Bei dem virtuellen Objekt kann es sich beispielsweise um eine virtuelle Maschine, eine virtuelle Absperrung, ein virtuelles Lager, um virtuelles Material, um virtuelle Werkstücke oder ähnliches handeln.

Auch die Bewegungen, Laufwege, Eingriffe usw. eines Menschen können mittels ähnlicher Technik in eine Simulation bzw. die virtuelle Umgebung überführt werden. Hierzu können Markierungen bzw. Marker an den Gelenken des Menschen angebracht werden und die Bewegungen aufgenommen und angezeigt werden.

In Weiterbildung der Erfindung ist die Anzeigeeinheit ein Smartphone, ein Tablet-Rechner, eine Augmented-Reality-Brille/Headset oder eine Virtual-Reality-Brille/Headset.

Als mobile Endgeräte kommen somit Geräte oder Systeme in Frage, die mit mindestens einer Kamera und einer Möglichkeit zur Visualisierung ausgestattet sind.

In Weiterbildung der Erfindung weisen die Markierungen mindestens einen Transponder auf.

Es ist nach der Weiterbildung vorgesehen, dass die visuellen Markierungen zusätzlich mit Funkortung versehen werden, beispielsweis mit UWB Technik. Beispielsweise können hier Airtags von Apple zum Einsatz kommen. Ein AirTag ist so konzipiert, dass es wie ein Schlüsselfinder funktioniert und dabei hilft, Schlüssel und andere Gegenstände mithilfe der Ultrabreitband-Technik (UWB) zu finden. Über den von Apple entwickelten U1-Chip lässt sich auch die genaue Distanz und Richtung zum gesuchten AirTag anzeigen.

In Weiterbildung der Erfindung ist das virtuelle Sensormodell konfigurierbar, wobei die Konfiguration des virtuellen Sensormodells auf den realen Sensor übertragbar ist.

Sensorkonfigurationen des virtuellen Sensors, z.B. eine Schutzfeldgröße eines virtuellen Laserscanners, können anhand des Umweltmodells und des über die Markierungen aufgespannten gewünschten Wirkbereichs von virtuellen Sensoren gespeichert werden und beispielsweise einem Kunden im Rahmen des Bestellprozesses für reale Sensoren zur Verfügung gestellt werden. Neben der einfachen und schnellen Planung von Applikationen unterstützt die Sensorkonfiguration ebenfalls die Einrichtung der realen Applikation.

In Weiterbildung der Erfindung wird nach einer virtuellen Planung mindestens eine virtuelle Lösung in eine Simulation überführt. Dadurch ist eine virtuelle Fortsetzung der Planung in einer Simulation möglich.

Im Anschluss an die virtuelle Planung können eine oder mehrere virtuelle Lösungen in eine Simulation überführt werden. In der Simulation können nun sowohl prozessrelevante Parameter beispielsweise Geschwindigkeiten, Bauteile pro Stunde usw., als auch sicherheitsrelevante Parameter beispielsweise Erfassungsbereiche, Erfassungsfelder, Schutzfelder, Warnfelder, Geschwindigkeiten, Laufwege und/oder Eingriffe durch Werker variiert und simuliert werden. Dadurch kann einerseits das Sicherheitskonzept weiter validiert werden und andererseits eine Produktivität sowie ein Mehrwert der Sicherheitslösung quantifiziert und gegenübergestellt werden. Es ist beispielsweise vorgesehen, dass in der virtuellen Planung die exakte Sensorposition und -orientierung optimiert wird. Anschließend können die Parameter der Sensoren nochmals optimiert werden.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Figur 1: ein System zur Planung einer Anwendung mit mindestens einer Markierung;
- Figur 2: ein System zur Planung einer Anwendung mit mindestens einer Markierung;
- Figur 3: ein weiteres System zur Planung einer Anwendung mit mindestens einer Markierung;
- Figur 4: eine beispielhafte Markierung;

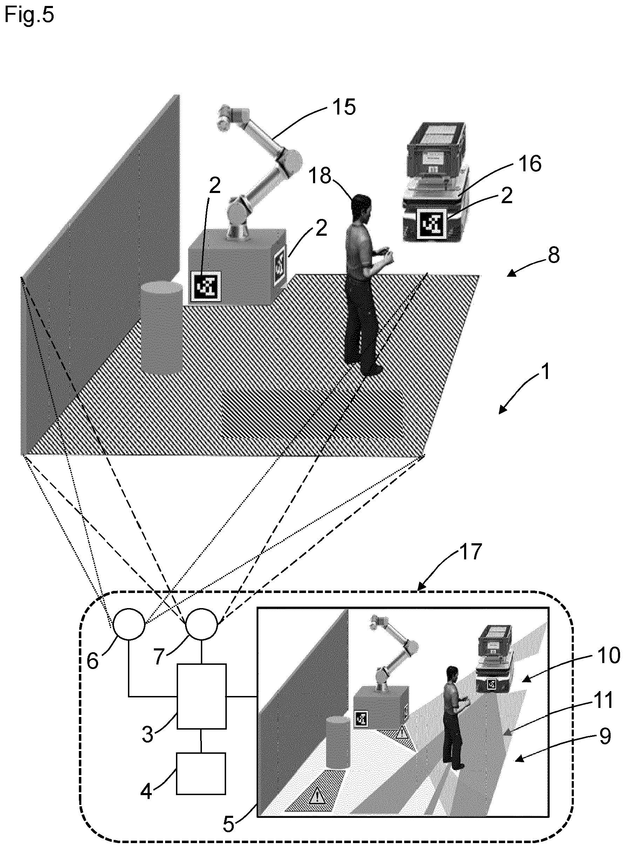

- Figur 5: ein weiteres System zur Planung einer Anwendung mit mindestens einer Markierung.

In den nachfolgenden Figuren sind identische Teile mit identischen Bezugszeichen versehen.

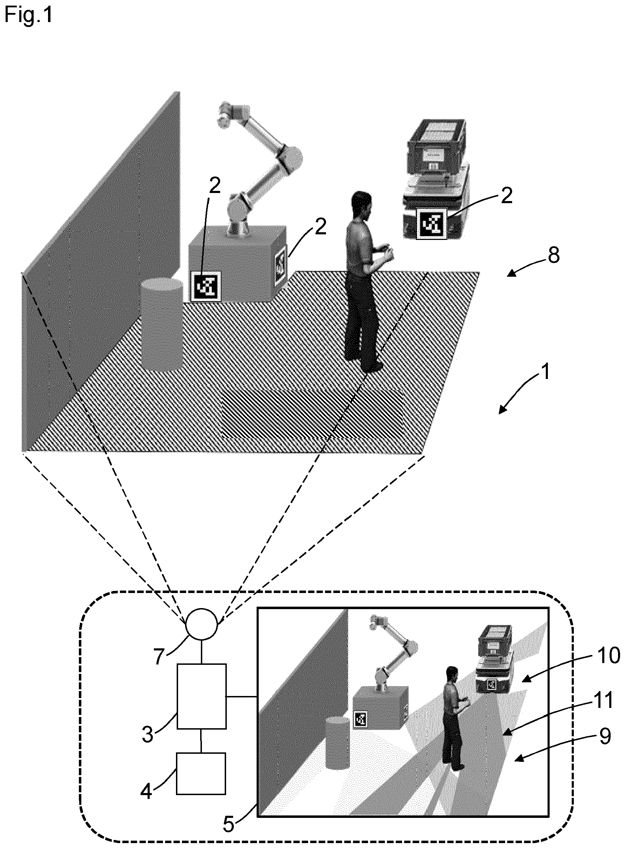

Figur 1 zeigt ein System 1 zur Planung einer Anwendung mit mindestens einer Markierung 2, mit einer Steuer- und Auswerteeinheit 3, mit einer Datenbank 4, mit einer Anzeigeeinheit 5, und mit mindestens einem räumlichen Modell einer realen Umgebung, und mindestens einer Kamera 7 zur Abbildung der realen Umgebung 8, wobei die reale Umgebung 8 in dem räumlichen Modell als virtuelle Umgebung 9 auf der Anzeigeeinheit 5 anzeigbar ist, wobei die Markierung 2 in der realen Umgebung 8 an einer Position und mit einer Orientierung angeordnet ist, wobei die Position und die Orientierung der Markierung 2 mindestens von der Kamera 7 erfassbar ist, wobei die Position und Orientierung der Markierung 2 mit einem virtuellen Sensormodell 10 verknüpft ist, wobei das virtuelle Sensormodell 10 in dem räumlichen Modell der virtuellen Umgebung 9 auf der Anzeigeeinheit an der Position und mit der Orientierung der Markierung 2 anzeigbar ist, wobei das virtuelle Sensormodell 10 mindestens einen virtuellen Erfassungsbereich 11 aufweist, wobei der virtuelle Erfassungsbereich 11 im dem räumlichen Modell der virtuellen Umgebung 9 auf der Anzeigeeinheit 5 anzeigbar ist.

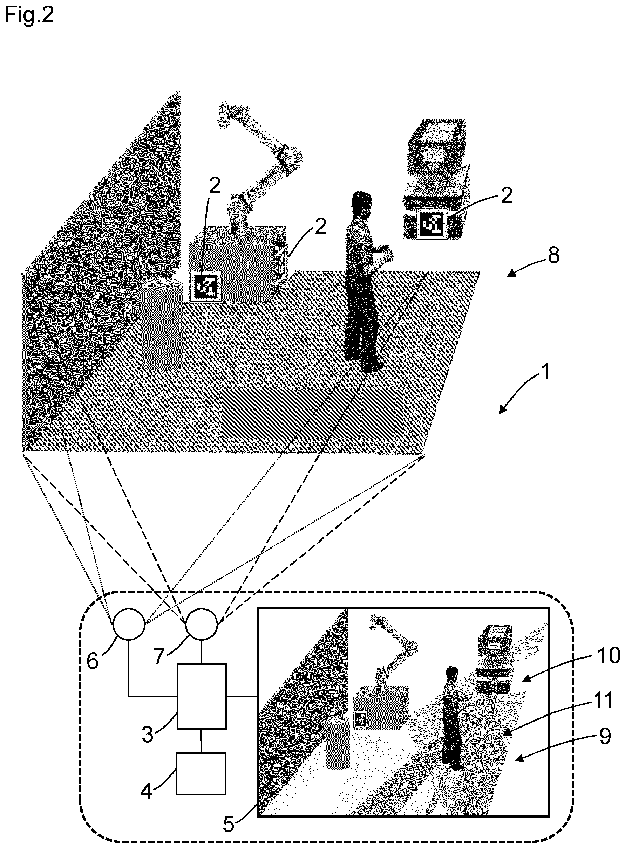

Figur 2 zeigt ein System 1 zur Planung einer Anwendung mit mindestens einer Markierung 2, mit einer Steuer und Auswerteeinheit 3, mit einer Datenbank 4, mit einer Anzeigeeinheit 5, und mit mindestens einem Lichtlaufzeitsensor 6 zur räumlichen Abtastung einer realen Umgebung, und mindestens einer Kamera 7 zur Abbildung der realen Umgebung, wobei die reale Umgebung in einem räumlichen Modell als virtuelle Umgebung 9 auf der Anzeigeeinheit 5 anzeigbar ist, wobei die Markierung 2 in der realen Umgebung 8 an einer Position und mit einer Orientierung angeordnet ist, wobei die Position und die Orientierung der Markierung 2 von dem Lichtlaufzeitsensor 6 erfassbar ist, wobei die Position und Orientierung der Markierung 2 mit einem virtuellen Sensormodell 10 verknüpft ist, wobei das virtuelle Sensormodell 10 in dem räumlichen Modell der virtuellen Umgebung 9 auf der Anzeigeeinheit 5 an der Position und mit der Orientierung der Markierung 2 anzeigbar ist, wobei das virtuelle Sensormodell 10 ein virtuelles Schutzfeld 11 aufweist, wobei das virtuelle Schutzfeld 11 im dem räumlichen Modell der virtuellen Umgebung 9 auf der Anzeigeeinheit 5 anzeigbar ist.

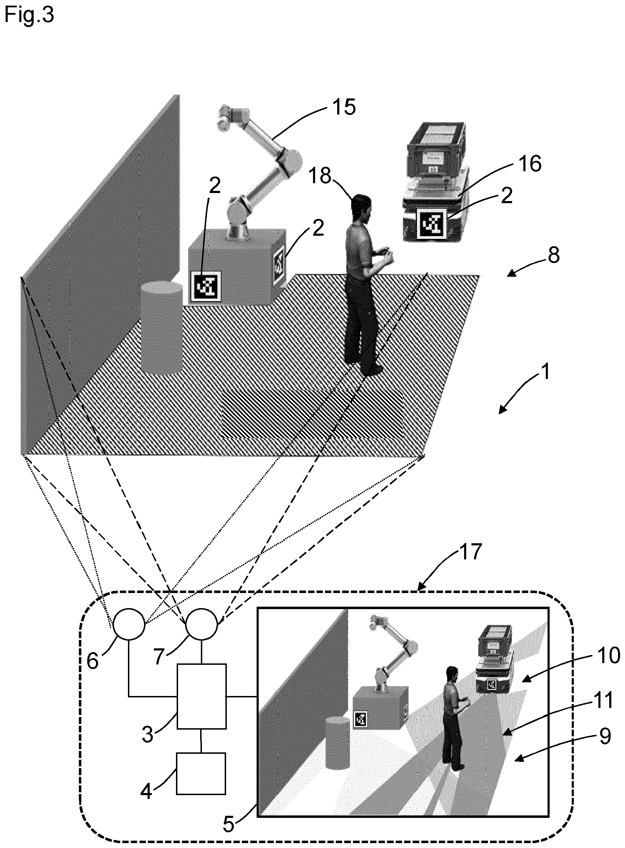

Figur 3 zeigt ein System gemäß Figur 2. Es wird beispielsweise ein Set von N Markierungen 2 bzw. Markern bzw. sog. visuellen Tags vorgesehen. Die Markierung 2 bzw. die Markierungen 2 werden in einer Umgebung einer geplanten Anwendung bzw. Applikation platziert oder angeordnet. Beispielsweise fest an einer Infrastruktur z.B. an einer Wand oder an einem Arbeitsplatz. Beispielsweise ist die Position eine ortsfeste Position und die Orientierung eine ortsfeste Orientierung.

Beispielsweise sind die Markierungen 2 an Manipulatoren z.B. an einem Roboter 15 oder an mobilen Plattformen 16 angeordnet. Beispielsweise ist die Position dann eine bewegliche veränderliche Position und die Orientierung ist eine bewegliche veränderliche Orientierung.

Jeder Markierung 2 kann nun per Software oder APP mittels der Steuer- und Auswerteeinheit 3 ein virtuelles Sensormodell 10 zugeordnet werden, welches in Augmented Reality also einer erweiterten Realität orientierungsgetreu mit Hilfe der Anzeigeeinheit 5 bzw. eines mobilen Endgeräts dargestellt wird. Insbesondere wird dabei auch der Wirkbereich des virtuellen Sensors und die Sensorfunktion des virtuellen Sensors in der erweiterten Realität dargestellt. Es kann auch vorgesehen sein auf dem digitalen Endgerät die relative Translation und Orientierung zw. Marker und augmentiertem Objekt einstellen zu können.

Beispielsweise ortet ein digitales Endgerät 17 hierfür mit dem Lichtlaufzeitsensor 6 optisch die Position und Orientierung der Markierungen 2 in der Umgebung der Anwendung mit dem Lichtlaufzeitsensor 6 und der Kamera 7. Hierbei werden beispielsweise drei unterschiedliche Raumrichtungen und drei unterschiedliche Orientierungen, also sechs Freiheitsgrade der Markierung 2 ermittelt. Der Lichtlaufzeitsensor 6, beispielsweise ein LIDAR Scanner erzeugt dabei das dazugehörige virtuelle Umweltmodell bzw. ein situatives Umweltmodell.

Die Umgebung bzw. ein Umweltmodell umfasst hier auch beispielsweise Personen 18, die sich in der realen Umgebung, beispielsweise einer Industrieszene befinden. Die Markierungen 2 werden nun dazu verwendet einer georteten Markierung 2 die entsprechende Sensorfunktion an Ort und Stelle bzw. der Position in korrekter Orientierung zuzuordnen und zu visualisieren.

Dabei penetrieren die Wirkbereiche der virtuellen Sensoren 10 keine virtuelle Infrastruktur, d.h. z.B. Wände, Fußböden oder Personen 18 werden in der Augmented Reality Visualisierung nicht durchstrahlt, sondern beispielsweise fotorealistisch getroffen. Ähnlich wie mit "Post-it-Notizen" kann so eine Applikation interaktiv und/oder immersiv sehr effizient und nachvollziehbar geplant werden.

Sensoren werden nur durch die Markierung 2 repräsentiert, der bestimmte Sensoreigenschaften zugewiesen werden können. Die einer Markierung 2 zugewiesenen Sensoreigenschaften werden augmentiert visualisiert.

Dabei kann eine Kenntnis über die relative Lage der Markierung 2 auch bei einer Ortsveränderung bzw. einer Orientierungsänderung der Markierung 2 aktualisiert werden.

Aus der Kombination von Bilddaten der Kamera 7 und von erzeugten Tiefenkarten des Lichtlaufzeitsensors 6 bei der Aufnahme der Umgebung und Erzeugung des Umgebungsmodells, können so die bereits platzierten Markierungen 2 in der Applikation erkannt und auch einem Ort bzw. Koordinaten in der Umgebung zugeordnet werden.

Bei einer Veränderung einer Markierungsposition oder dem Hinzufügen einer weiteren Markierung 2 braucht nur der Bereich um die neue Position aufgenommen werden, bis der Algorithmus genügend Referenzen hat, um die Markierung 2 korrekt neu zu platzieren in der virtuellen Umgebung. Dies könnte auch in Echtzeit erfolgen, sofern das zur Visualisierung verwendete Endgerät 17 über die entsprechende Sensorik verfügt.

Erfolgt die Umgebungserfassung in Echtzeit z.B. über das zur Visualisierung genutzte Endgerät können auch bewegliche Objekte berücksichtigt werden.

Nach erfolgreicher Planung können die Ergebnisse mittels Screenshots oder Videos dokumentiert werden und in die Applikationsdokumentation überführt werden, z.B. im Rahmen eines Risiko Assessment.

Die in der Simulation verwendeten virtuellen Sensoren 10 können beispielsweise in einem Werkzeug der Steuer- und Auswerteeinheit 3 in einen Einkaufskorb platziert werden und vom Kunden als reale Sensoren bezogen werden.

Aus der Simulation gebildete Sensor-Konfigurationen können beispielsweise als Parameterdatei ebenfalls an Kunden geliefert werden. Dadurch wird neben der einfachen und schnellen Planung von Applikationen auch die einfache und schnelle Einrichtung der realen Applikation ermöglicht und gefördert.

Die in der realen Umgebung 8 angebrachten Markierungen 2 können einem Integratoren-Team auch als Montagehinweis dienen. Beispielsweise können in der virtuellen Umgebung 9 Montagehinweise, insbesondere Textnachrichten eingeblendet werden, beispielsweise mit dem Wortlaut: "Hier bitte einen Sensor X in dieser dargestellten Orientierung Y mit einem Parameterset Z anbringen".

Im Anschluss an die virtuelle Planung können eine oder mehrere virtuelle Lösungen in eine Simulation überführt werden. In der Simulation können nun sowohl prozessrelevante Parameter beispielsweise Geschwindigkeiten, Bauteile pro Stunde usw., als auch sicherheitsrelevante Parameter beispielsweise Schutzfelder, Geschwindigkeiten, Laufwege und/oder Eingriffe durch Werker variiert und simuliert werden. Dadurch kann einerseits das Sicherheitskonzept weiter validiert werden und andererseits eine Produktivität sowie ein Mehrwert der Sicherheitslösung quantifiziert und gegenübergestellt werden.

Es ist eine Applikationsplanung durch den Anwender in der künftigen Produktionsumgebung möglich, beispielsweise eine Mensch-Roboter-Kollaboration (MRK). Ein Anwender erstellt ein 3D Umweltmodell in der virtuellen Umgebung 9. Es erfolgt eine Simulation und Visualisierung der Absicherung der Gefahrenstellen durch Platzieren von Markierungen 2 in der Umgebung die flexibel über eine SICK Bibliothek mit verschiedenen virtuellen Sensoren und deren Eigenschaften verknüpft werden können. Der Anwender kann so seine Applikation virtuell planen und simulieren, Sensor-Konfigurationen speichern und über die APP eine individualisierte Bestellung aufgeben. Der Kunde erhält, auf Basis seines Umweltmodels, vorkonfigurierte Sensoren inkl. Montagehinweis. Nach Installation der realen Applikation, kann eine Validierung vorgenommen werden, wobei die Simulation in der virtuellen Umgebung 9 mit der realen Anwendung verglichen wird. Abweichungen werden erkannt und können nachjustiert werden.

Wie bei der beschriebenen Mensch-Roboter-Kollaboration (MRK) Anwendung kann beispielsweise bei einer autonomen mobilen Roboteranwendung (AMR) ebenfalls die Applikationsplanung von Workstations durchgeführt werden. Dazu erstellt der Anwender ein 3D Umweltmodell in der virtuellen Umgebung 9. Durch Platzieren von Markierungen 2 oder Markern, die mit virtuellen Sensoren 10 und deren Eigenschaften verknüpft sind, lässt sich die Absicherung der Gefahrenstelle simulieren und visualisieren. Ebenfalls kann der Anwender so seine Applikation in Augmented Reality planen und simulieren, Sensor-Konfigurationen speichern und über die App eine individualisierte Bestellung aufgeben. Darüber hinaus können bei einer autonomen mobilen Roboteranwendung (AMR) nicht nur Workstations simuliert und visualisiert werden, sondern auch Wegabschnitte. Dazu kann ein live 3D Umweltmodell erstellt werden und potenzielle Gefahrenstellen in der Wegplanung simuliert werden.

Gemäß Figur 3 ist der Lichtlaufzeitsensor 6 beispielsweise ein Laserscanner oder eine 3D-Lichtlaufzeitkamera.

Sensorkonfigurationen des virtuellen Sensors 10, z.B. eine Schutzfeldgröße eines virtuellen Laserscanners, können anhand des Umweltmodells und des über die Markierungen 2 aufgespannten gewünschten Wirkbereichs von virtuellen Sensoren 10 gespeichert werden und beispielsweise einem Kunden im Rahmen des Bestellprozesses für reale Sensoren zur Verfügung gestellt werden. Neben der einfachen und schnellen Planung von Applikationen unterstützt die Sensorkonfiguration ebenfalls die Einrichtung der realen Applikation.

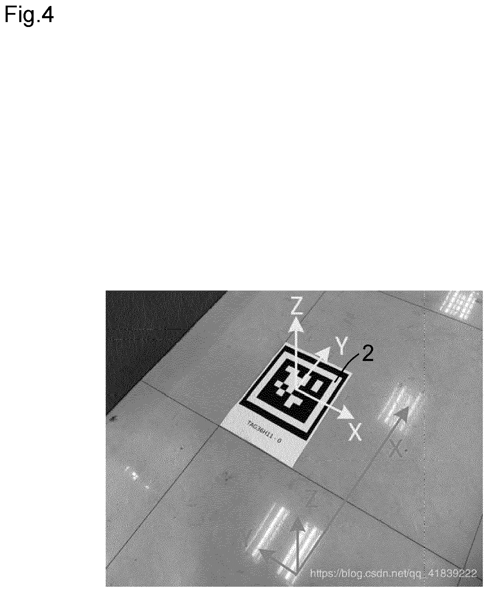

Gemäß Figur 3 sind beispielsweise zwei Markierungen 2 beispielsweise an einem Roboter 15 ortsfest angeordnet und sollen einen bestimmten Bereich um den Roboter 15 erfassen und absichern. Es ist beispielsweise vorgesehen, dass man diesen Bereich ebenfalls per mobilem Endgerät 17 in der Applikation eingibt bzw. einzeichnet und somit Bereiche identifiziert, die nicht von den Sicherheitssensoren in ihrer aktuellen Anbringung und Konfiguration erfasst werden. Solche Bereiche entstehen z.B. hinter statischen Objekten, an denen die Schutzfelder aufgrund der eingelernten Umgebungsdaten abgeschnitten werden. Hier können beispielsweise wie in Figur 4 dargestellt Warnhinweise, beispielsweise symbolisch mit Ausrufezeichen in der virtuellen Umgebung angezeigt werden.

Auch an bewegten Hindernissen, wie z.B. der Person 18 oder der mobilen Plattform 16 können die Schutzfelder unterbrochen bzw. abgeschnitten werden. Prinzipiell sind auch Markierungen 2 an beweglichen Maschinenteilen oder Fahrzeugen vorgesehen.

Eine Korrespondenz zwischen den Markierungen 2 und den virtuellen Sensoren 10 kann beispielsweise wie folgt aussehen:
Die Datenmodelle von virtuellen Sensoren 10 sind beispielsweise in einer Bibliothek der Datenbank 4 abgelegt. Diese Bibliothek umfasst beispielsweise für jeden Sensor das 3D-CAD-Modell, einen Wirkbereich und ein Set an Funktionen. Zusätzlich werden beispielsweise für jeden Sensor Metadaten abgelegt, diese können beispielsweise einen Sensortyp (z. B. Laserscanner, 3D-Lichtlaufzeitkamera, etc), physikalische Anschlüsse (z. B. Ethernet, IO-Link, etc) oder einen Performance Level umfassen. Die Bibliothek bzw. Sensorbibliothek kann mit Suchfiltern ausgestattet sein, so dass der Anwender entscheiden kann, welche virtuellen Sensoren 10 er für die Zuordnung verwenden möchte (z.B. eine 3D-Lichtlaufzeitkamera mit 940 nm Wellenlänge, 3 m Reichweite, 70° Sichtbereich und Ethernet Anschluss). Einem morphologischen Kasten ähnelnd können den Markierungen unterschiedliche Sensoren zugeordnet werden, die dann zur Planung der Applikation verwendet werden.

Gemäß Figur 3 und Figur 4 sind die Markierungen 2 zweidimensionale Matrixkodierungen. Dabei ist aus der zweidimensionalen Matrixkodierung die eindeutige Richtung und die eindeutige Orientierung der Markierung 2 erkennbar und ermittelbar. Die Matrixkodierung kann optional die Art des Sensors, sowie weitere Eigenschaften des Sensors, wie beispielsweise eine Schutzfeldgröße, eine Schutzfeldrichtung und eine Schutzfeldorientierung aufzeigen.

Gemäß Figur 3 ist die Markierung 2 mittels einer Haltevorrichtung in der realen Umgebung angeordnet.

Beispielsweise sind universell passende Aufhängungen vorgesehen, um die Markierungen 2 zur Planung möglichst frei in der Applikation platzieren zu können. Beispielsweise ist ein modulares Anbringungskonzept bestehend aus Grundplatte mit der Markierung in Kombination mit wahlweise einer magnetischen Vorrichtung, einer Klebevorrichtung, einer Klemmvorrichtung und/oder einer Schraubvorrichtung vorgesehen.

Beispielsweise ist die Position und Orientierung einer zweiten Markierung 2 mit einem virtuellen Objekt verknüpft, wobei das virtuelle Objekt in dem räumlichen Modell der Umgebung auf der Anzeigeeinheit an der Position und mit der Orientierung der zweiten Markierung 2 angezeigt wird.

Bei dem virtuellen Objekt kann es sich beispielsweise um eine virtuelle Maschine, eine virtuelle Absperrung, ein virtuelles Lager, um virtuelles Material, um virtuelle Werkstücke oder ähnliches handeln.

Auch die Bewegungen, Laufwege, Eingriffe usw. einer Person 18 können mittels ähnlicher Technik in eine Simulation bzw. die virtuelle Umgebung überführt werden. Hierzu können Markierungen 2 bzw. Marker an den Gelenken der Person 18 angebracht werden und die Bewegungen aufgenommen und angezeigt werden.

Gemäß Figur 3 ist die Anzeigeeinheit beispielsweise ein Smartphone, ein Tablet-Rechner, eine Augmented-Reality-Brille/Headset oder eine Virtual-Reality-Brille/Headset.

Als mobile bzw. digitale Endgeräte 17 kommen somit Geräte oder Systeme in Frage, die mit mindestens einer Kamera und einer Möglichkeit zur Visualisierung ausgestattet sind.

Gemäß Figur 3 weisen die Markierungen 2 beispielsweise einen Transponder auf.

Es ist beispielsweise vorgesehen, dass die visuellen Markierungen zusätzlich mit Funkortung versehen werden, beispielsweise mit UWB Technik.

### Bezugszeichen:

1 System
2 Markierung
3 Steuer- und Auswerteeinheit
4 Datenbank
5 Anzeigeeinheit
6 3D-Sensor
7 Kamera
8 reale Umgebung
9 virtuelle Umgebung
10 virtuelles Sensormodell/virtueller Sensor
11 virtuelles Schutzfeld
15 Roboter
16 mobile Plattformen
17 digitales Endgerät
18 Person

## Patentansprüche

1. System (1) zur Planung einer Anwendung mit mindestens einer Markierung (2), mit einer Steuer- und Auswerteeinheit (3), mit einer Datenbank (4), mit einer Anzeigeeinheit (5), und mit mindestens einem räumlichen Modell einer realen Umgebung, und mindestens einer Kamera (7) zur Abbildung der realen Umgebung (8),
wobei die reale Umgebung (8) in dem räumlichen Modell als virtuelle Umgebung (9) auf der Anzeigeeinheit (5) anzeigbar ist,
wobei die Markierung (2) in der realen Umgebung (8) an einer Position und mit einer Orientierung angeordnet ist,
wobei die Position und die Orientierung der Markierung (2) mindestens von der Kamera (7) erfassbar sind,
**dadurch gekennzeichnet, dass** die Position und Orientierung der Markierung (2) mit einem virtuellen Sensormodell (10) verknüpft ist,
wobei das virtuelle Sensormodell (10) in dem räumlichen Modell der virtuellen Umgebung (9) auf der Anzeigeeinheit an der Position und mit der Orientierung der Markierung (2) anzeigbar ist,
wobei das virtuelle Sensormodell (10) mindestens einen virtuellen Erfassungsbereich (11) aufweist, wobei der virtuelle Erfassungsbereich (11) im dem räumlichen Modell der virtuellen Umgebung (9) auf der Anzeigeeinheit (5) anzeigbar ist.

2. System (1) nach Anspruch 1, **dadurch gekennzeichnet, dass** das räumliche Modell auf Basis einer realen Umgebung als CAD-Modell vorhanden ist.

3. System (1) nach Anspruch 1, **dadurch gekennzeichnet, dass** das räumliche Modell mittels einem 3D-Sensor (6) gebildet wird oder gebildet wurde.

4. System (1) nach Anspruch 3, **dadurch gekennzeichnet, dass** die Position und die Orientierung der Markierung (2) von dem 3D-Sensor (6) und der Kamera (7) erfassbar sind.

5. System (1) nach Anspruch 3, **dadurch gekennzeichnet, dass** der 3D-Sensor (6) eine Stereokamera oder ein Lichtlaufzeitsensor ist.

6. System (1) nach Anspruch 1, **dadurch gekennzeichnet, dass** der Lichtlaufzeitsensor ein Laserscanner oder eine 3D-Lichtlaufzeitkamera ist.

7. System (1) nach einem der vorhergehenden Ansprüche, **dadurch gekennzeichnet, dass** die Markierungen (2) mindestens zweidimensionale Matrixkodierungen sind.

8. System (1) nach einem der vorhergehenden Ansprüche, **dadurch gekennzeichnet, dass** die Markierungen (2) mindestens reale 3D-Modelle sind.

9. System (1) nach einem der vorhergehenden Ansprüche, **dadurch gekennzeichnet, dass** die Markierung (2) mittels einer Haltevorrichtung in der realen Umgebung (8) angeordnet ist.

10. System (1) nach einem der vorhergehenden Ansprüche, **dadurch gekennzeichnet, dass** die Position und Orientierung einer zweiten Markierung (2) mit einem virtuellen Objekt verknüpft ist, wobei das virtuelle Objekt in dem räumlichen Modell der virtuellen Umgebung (9) auf der Anzeigeeinheit (5) an der Position und mit der Orientierung der zweiten Markierung (2) angezeigt wird.

11. System (1) nach einem der vorhergehenden Ansprüche, **dadurch gekennzeichnet, dass** die Anzeigeeinheit (5) ein Smartphone, ein Tablet-Rechner, eine Augmented-Reality-Brille/Headset oder eine Virtual-Reality-Brille/Headset ist.

12. System (1) nach einem der vorhergehenden Ansprüche, **dadurch gekennzeichnet, dass** die Markierungen (2) mindestens einen Transponder aufweisen.

13. System (1) nach einem der vorhergehenden Ansprüche, **dadurch gekennzeichnet, dass** das virtuelle Sensormodell konfigurierbar ist, wobei die Konfiguration des virtuellen Sensormodells auf den realen Sensor übertragbar ist.

14. System (1) nach einem der vorhergehenden Ansprüche, **dadurch gekennzeichnet, dass** nach einer virtuellen Planung mindestens eine virtuelle Lösung in eine Simulation überführt wird.

15. Verfahren mit einem System (1) zur Planung einer Anwendung mit mindestens einer Markierung (2), mit einer Steuer- und Auswerteeinheit (3), mit einer Datenbank (4), mit einer Anzeigeeinheit (5), und mit mindestens einem räumlichen Modell einer realen Umgebung, und mindestens einer Kamera (7) zur Abbildung der realen Umgebung (8),
wobei die reale Umgebung (8) in dem räumlichen Modell als virtuelle Umgebung (9) auf der Anzeigeeinheit (5) angezeigt wird,
wobei die Markierung (2) in der realen Umgebung (8) an einer Position und mit einer Orientierung angeordnet wird,
wobei die Position und die Orientierung der Markierung (2) mindestens von der Kamera (7) erfasst wird,
**dadurch gekennzeichnet, dass** die Position und Orientierung der Markierung (2) mit einem virtuellen Sensormodell (10) verknüpft wird,
wobei das virtuelle Sensormodell (10) in dem räumlichen Modell der virtuellen Umgebung (9) auf der Anzeigeeinheit an der Position und mit der Orientierung der Markierung (2) angezeigt wird,
wobei das virtuelle Sensormodell (10) mindestens einen virtuellen Erfassungsbereich (11) aufweist, wobei der virtuelle Erfassungsbereich (11) im dem räumlichen Modell der virtuellen Umgebung (9) auf der Anzeigeeinheit (5) angezeigt wird.

## Claims

1. A system (1) for planning an application having at least one marking (2), having a control and evaluation unit (3), having a database (4), having a display unit (5), and having at least one spatial model of a real environment, and at least one camera (7) for imaging the real environment (8);
wherein the real environment (8) in the spatial model can be displayed as a virtual environment (9) on the display unit (5);
wherein the marking (2) in the real environment (8) is arranged at a position and having an orientation;
wherein the position and the orientation of the marking (2) can be detected at least by the camera (7);
**characterized in that** the position and orientation of the marking (2) are linked to a virtual sensor model (10);
with the visual sensor model (10) in the spatial model of the virtual environment (9) being able to be displayed on the display unit at the position and having the orientation of the marking (2); and
with the virtual sensor model (10) having at least one virtual detection zone (11), with the virtual detection zone (11) in the spatial model of the virtual environment (9) being able to be displayed on the display unit (5).

2. A system (1) in accordance with claim 1, **characterized in that** the spatial model is present as a CAD model on the basis of a real environment.

3. A system (1) in accordance with claim 1, **characterized in that** the spatial model is formed or was formed by means of a 3D sensor (6).

4. A system (1) in accordance with claim 3, **characterized in that** the position and the orientation of the marking (2) can be detected by the 3D sensor (6) and the camera (7).

5. A system (1) in accordance with claim 3, **characterized in that** the 3D sensor (6) is a stereo camera or a time of flight sensor.

6. A system (1) in accordance with claim 1, **characterized in that** the time of flight sensor is a laser scanner or is a 3D time of flight camera.

7. A system (1) in accordance with any one of the preceding claims, **characterized in that** the markings (2) are at least two-dimensional matrix encodings.

8. A system (1) in accordance with any one of the preceding claims, **characterized in that** the markings (2) are at least real 3D models.

9. A system (1) accordance with any one of the preceding claims, **characterized in that**: the marking (2) is arranged in the real environment (8) by means of a holding device.

10. A system (1) in accordance with any one of the preceding claims, **characterized in that** the position and orientation of a second marking (2) is linked to a virtual object, with the virtual object in the spatial model of the virtual environment (9) being displayed on the display unit (5) at the position and having the orientation of the second marking (2).

11. A system (1) in accordance with any one of the preceding claims, **characterized in that** the display unit (5) is a smartphone, a tablet computer, augmented reality glasses/headset, or virtual reality glasses/headset it.

12. A system (1) in accordance with any one of the preceding claims, **characterized in that** the markings (2) have at least one transponder.

13. A system (1) in accordance with any one of the preceding claims, **characterized in that** the virtual sensor model is configurable, with the configuration of the virtual sensor model being able to be transferred to the real sensor.

14. A system (1) in accordance with any one of the preceding claims, **characterized in that** at least one virtual solution is transferred to a simulation after a virtual planning.

15. A method using a system (1) for planning an application having at least one marking (2), having a control and evaluation unit (3), having a database (4), having a display unit (5), and having at least one spatial model of a real environment, and at least one camera (7) for imaging the real environment (8);
wherein the real environment (8) in the spatial model is displayed as a virtual environment (9) on the display unit (5);
wherein the marking (2) in the real environment (8) is arranged at a position and having an orientation;
wherein the position and the orientation of the marking (2) are detected at least by the camera (7);
**characterized in that** the position and orientation of the marking (2) are linked to a virtual sensor model (10);
with the visual sensor model (10) in the spatial model of the virtual environment (9) being able to be displayed on the display unit at the position and having the orientation of the marking (2); and
with the virtual sensor model (10) having at least one virtual detection zone (11), with the virtual detection zone (11) in the spatial model of the virtual environment (9) being displayed on the display unit (5).

## Revendications

1. Système (1) de planification d'une application, comprenant au moins un marquage (2), une unité de commande et d'évaluation (3), une base de données (4), une unité d'affichage (5), et au moins un modèle spatial d'un environnement réel, et au moins une caméra (7) pour représenter l'environnement réel (8),
dans lequel
l'environnement réel (8) peut être affiché dans le modèle spatial comme environnement virtuel (9) sur l'unité d'affichage (5),
le marquage (2) est agencé dans l'environnement réel (8) à une position et avec une orientation,
la position et l'orientation du marquage (2) peuvent être détectées au moins par la caméra (7),
**caractérisé en ce que** la position et l'orientation du marquage (2) sont liées à un modèle de capteur virtuel (10),
le modèle de capteur virtuel (10) pouvant être affiché dans le modèle spatial de l'environnement virtuel (9) sur l'unité d'affichage à la position et avec l'orientation du marquage (2),
le modèle de capteur virtuel (10) présentant au moins une zone de détection virtuelle (11), la zone de détection virtuelle (11) pouvant être affichée dans le modèle spatial de l'environnement virtuel (9) sur l'unité d'affichage (5).

2. Système (1) selon la revendication 1,
**caractérisé en ce que** le modèle spatial existe sous forme de modèle CAO sur la base d'un environnement réel.

3. Système (1) selon la revendication 1,
**caractérisé en ce que** le modèle spatial est formé ou a été formé au moyen d'un capteur 3D (6).

4. Système (1) selon la revendication 3,
**caractérisé en ce que** la position et l'orientation du marquage (2) peuvent être détectées par le capteur 3D (6) et par la caméra (7).

5. Système (1) selon la revendication 3,
**caractérisé en ce que** le capteur 3D (6) est une caméra stéréoscopique ou un capteur de temps de parcours de lumière.

6. Système (1) selon la revendication 1,
**caractérisé en ce que** le capteur de temps de parcours de lumière est un scanner laser ou une caméra 3D à temps de parcours de lumière.

7. Système (1) selon l'une des revendications précédentes,
**caractérisé en ce que** les marquages (2) sont au moins des codages matriciels bidimensionnels.

8. Système (1) selon l'une des revendications précédentes,
**caractérisé en ce que** les marquages (2) sont au moins des modèles 3D réels.

9. Système (1) selon l'une des revendications précédentes,
**caractérisé en ce que** le marquage (2) est agencé dans l'environnement réel (8) au moyen d'un dispositif de maintien.

10. Système (1) selon l'une des revendications précédentes,
**caractérisé en ce que** la position et l'orientation d'un deuxième marquage (2) sont liées à un objet virtuel, l'objet virtuel étant affiché dans le modèle spatial de l'environnement virtuel (9) sur l'unité d'affichage (5) à la position et avec l'orientation du deuxième marquage (2).

11. Système (1) selon l'une des revendications précédentes,
**caractérisé en ce que** l'unité d'affichage (5) est un smartphone, une tablette, un casque/lunettes de réalité augmentée ou un casque/lunettes de réalité virtuelle.

12. Système (1) selon l'une des revendications précédentes,
**caractérisé en ce que** les marquages (2) comprennent au moins un transpondeur.

13. Système (1) selon l'une des revendications précédentes,
**caractérisé en ce que** le modèle de capteur virtuel est configurable, la configuration du modèle de capteur virtuel pouvant être transmise au capteur réel.

14. Système (1) selon l'une des revendications précédentes,
**caractérisé en ce qu'**après une planification virtuelle, au moins une solution virtuelle est transférée vers une simulation.

15. Procédé avec un système (1) pour la planification d'une application, comprenant au moins un marquage (2), une unité de commande et d'évaluation (3), une base de données (4), une unité d'affichage (5), et au moins un modèle spatial d'un environnement réel, et au moins une caméra (7) pour la représentation de l'environnement réel (8),
dans lequel
l'environnement réel (8) est affiché dans le modèle spatial comme environnement virtuel (9) sur l'unité d'affichage (5),
le marquage (2) est agencé dans l'environnement réel (8) à une position et avec une orientation,
la position et l'orientation du marquage (2) sont détectées au moins par la caméra (7),
**caractérisé en ce que** la position et l'orientation du marquage (2) sont liées à un modèle de capteur virtuel (10),
le modèle de capteur virtuel (10) étant affiché dans le modèle spatial de l'environnement virtuel (9) sur l'unité d'affichage à la position et avec l'orientation du marquage (2),
le modèle de capteur virtuel (10) présentant au moins une zone de détection virtuelle (11), la zone de détection virtuelle (11) étant affichée dans le modèle spatial de l'environnement virtuel (9) sur l'unité d'affichage (5).
